# EUROPEAN PATENT APPLICATION

(11) **EP 2 669 827 A2**
(43) Date of publication of application: **04.12.2013**
(21) Application number: 13157976.5
(22) Date of filing: 06.03.2013
(51) Int. Cl.: G06F 17/50

(54) **Numerical simulation of a structure having a heat-affected zone using a finite element analysis model**

(30) Priority: 29.05.2012 US 201213482872
(71) Applicant: Livermore Software Technology Corporation, Livermore CA 94551 (US)
(72) Inventor: Hallquist, John O., Livermore, CA California 94551 (US)
(74) Representative: Becker Kurig Straus

(57) **Abstract**

Methods and systems for conducting numerical simulation of a structure having heat affected zones (HAZ) using a finite element anaysis (FEA) model are disclosed. A FEA model that includes at least a group of finite elements representing a welded structural part that encompasses at least one HAZ is defined and received in a computer system. Each finite element in the group is configured with at least one integration point according to FEA. The group of finite elements is associated with a set of HAZ material properties representing structural behavior of the welded structural part inside and outside the HAZ. Corresponding material properties are then determined and assigned to each integration point by interpolating the associated set using the shortest heat-propagation distance between each integration point and the heat source locations (e.g., spotwelds' centroid) with an automated procedure that requires no additional input after the HAZ material properties have been defined.

## Description

### FIELD OF THE INVENTION

The present invention generally relates to computer aided engineering analysis, more particularly to methods and systems for conducting a numerical simulation of a structure having heat-affected zone, which is located in the vicinity of heat sources (e.g., welding).

### BACKGROUND OF THE INVENTION

Computer aided engineering (CAE) has been used for supporting engineers in many tasks. For example, in a structure or engineering product design procedure, CAE analysis, particularly finite element analysis (FEA), has often been employed to predict structural behavior (e.g., stresses, displacements, etc.) under various simulated loading conditions (e.g., static or dynamic).

FEA is a computerized method widely used in industry to numerically simulate (i.e., model and solve in a computer system) engineering problems relating to complex products or systems (e.g., cars, airplanes, consumer products, etc.) such as three-dimensional non-linear structural design and analysis. FEA derives its name from the manner in which the geometry of the object under consideration is specified. The geometry is defined by elements and nodal points. There are a number of types of elements, solid elements for volumes or continua, shell or plate elements for surfaces and beam or truss elements for one-dimensional structural objects. The geometry of each element is defined by nodal points, for example, a brick or hexahedral element comprising eight corner nodes.

FEA has been used for estimating automobile crashworthiness. Numerical simulation of an impact event (e.g., car crash) using FEA has been improved significantly with advent of computer technology. In recent years, attentions have been paid to numerically simulate structural behavior within a heat-affected zone (HAZ) near a heat source (e.g., a spotweld, a butt weld seam).

Heat-affected zone is the area of a material whose properties altered by high heat (e.g., welding). For example, use of Metal Inert Gas welding induces material strength reductions in the HAZ. As a result, lines of weakness are created in the vicinity of the heat sources for potential structural failure, particularly under crash loading. Material properties (e.g., stress-strain relationship) within the HAZ are altered comparing to those of the base material. In general, material properties within HAZ vary by the distance measured from a heat source location (i.e., the center of a spotweld).

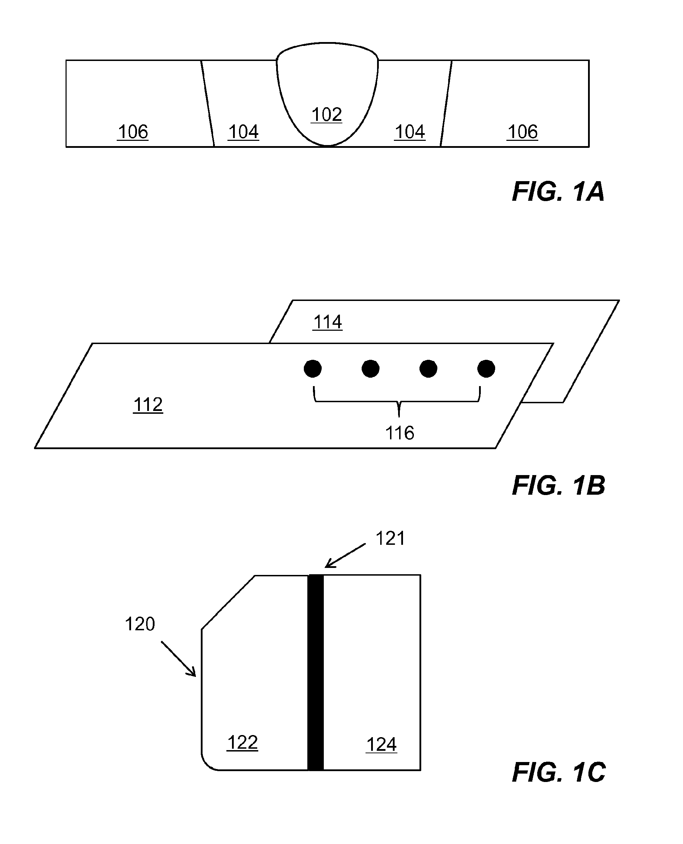

FIG. 1A is a diagram showing a cross-section of a weld 102 and surrounding HAZ 104. The base material 106 unaffected by the heat locates outside the HAZ. Two structural parts (i.e., two plates 112 and 114 are connected together by the spotwelds 116 are shown in FIG. 1B. HAZ is located around each of the spotwelds 116.

FIG. 1C is a plan view of a tailor welded blank (TWB) sheet metal 120, which is joined together of two plates 122 and 124 with a butt weld 121 (shown in black). Not only plates 122 and 124 have different geometric shape, they may have a different thickness. A structural part could be made from TWB 120 using metal stamping process. The HAZ is located at either side of the butt weld 121.

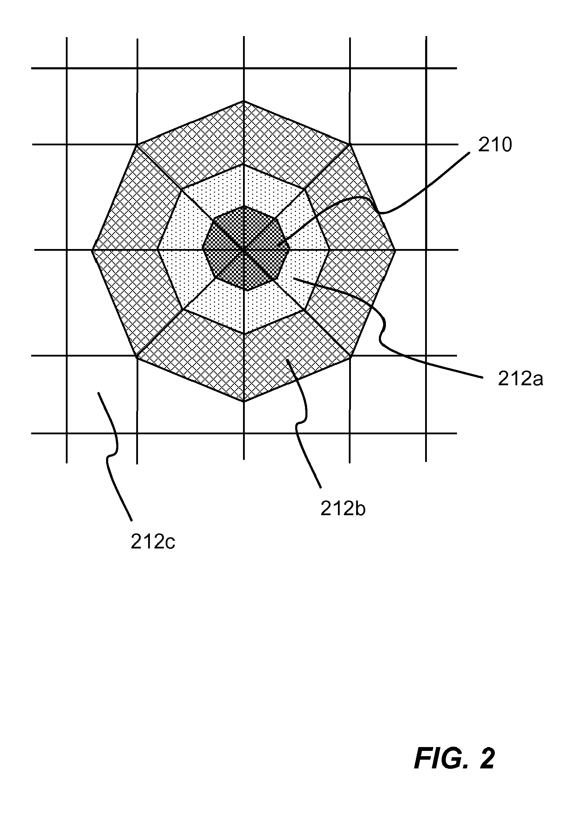

Prior art approaches for modeling such effects have been to create several layers of finite elements 212a-212c surrounding a weld 210 in an exemplary FEA model shown in FIG. 2. Each layer is assigned with different material properties with respect to the distance from the heat source. Within a given finite element, each integration point is assigned the same material properties, i.e., the constitutive constants do not change regardless of the distance from the spotweld's center. The weld 210 can be represented with a beam element, a single solid element, a cluster of solid elements. a rigid element, or a weighted average constraint element. The nodal points comprising the welds are constrained to the welded parts automatically using tied contact interfaces. One of the problems with these prior approaches is the tedious input requirements. It requires the user to define numerous material properties to account for different distances from the heat source, which made it difficult to change the model configuration (e.g., size of the element near the heat source). Moreover, the task of creating a FEA model is labor intensive since a vehicle contains thousands of spotwelds. Finally, any modification of the configuration can require defining additional material properties and assigning different material properties to those modified elements in the HAZ.

It would, therefore, be desirable to have efficient numerical simulation methods of a structure containing HAZ using a FEA model.

### BRIEF SUMMARY OF THE INVENTION

Methods and systems for conducting numerical simulation of a structure having at least one heat-affected zone using a FEA model are disclosed. According to one exemplary embodiment of the present invention, a FEA model includes at least a group of finite elements representing a welded structural part that encompasses at least one HAZ is defined and received in a computer system having a FEA application module installed thereon. Each finite element in the group is configured with at least one integration point based on FEA. The group of finite elements is associated with a set of HAZ material properties representing structural behavior of the welded structural part inside and outside the HAZ. Corresponding material properties are then determined and assigned to each integration point by interpolating the associated set using the shortest heat-propagation distance between each integration point and the heat source locations (e.g., spotwelds' centroid). A numerical simulation of the structure can then be conducted using the FEA model with corresponding numerical material properties determined at each integration point. According to another aspect of the present invention, the parts in a FEA model that reference the HAZ constitutive model are automatically initiated and no other input is necessary. The present invention eliminates the need for the complex meshing techniques (e.g., the FEA mesh in FIG. 2) presently used in industry.

Objects, features, and advantages of the present invention will become apparent upon examining the following detailed description of an embodiment thereof, taken in conjunction with the attached drawings.

### BRIEF DESCRIPTION OF THE DRAWINGS

These and other features, aspects, and advantages of the present invention will be better understood with regard to the following description, appended claims, and accompanying drawings as follows:

FIG. 1A is a diagram showing a cross-section area of an exemplary weld and its vicinity including heat-affected zone;

FIG. 1B is a schematic diagram showing two exemplary structural parts connected together by spotwelds;

FIG. 1C is a diagram showing a plan view of an exemplary tailor welded blanket sheet metal;

FIG. 2 is a diagram showing a plan view of a portion of an exemplary finite element analysis model near a weld;

FIG. 3 is a flowchart illustrating an exemplary process of conducting numerical simulation of a structure having heat-affected zone (HAZ) using a finite element analysis (FEA) model, according to an embodiment of present invention;

FIGS. 4A-4D show various exemplary finite elements that can be used for representing a welded structural part inside and outside of a HAZ, according to an embodiment of the present invention;

FIG. 5 is a diagram showing an exemplary FEA model, according to an embodiment of the present invention;

FIG. 6A is a X-Y diagram illustrating an exemplary HAZ material properties that can be associated with a group of finite elements representing a part's structural behavior inside and outside of a HAZ, according to an embodiment of the present invention;

FIG. 6B is a X-Y diagram showing an exemplary relationship of stress versus distances from a heat source location (i.e., a weld), according to an embodiment of the present invention;

FIGS. 7A-7C are schematic diagrams showing the spatial relationship between an exemplary finite element with its integration points and spotwelds in accordance with one embodiment of the present invention; and

FIG. 8 is a function diagram showing salient components of a computer system, in which an embodiment of the present invention may be implemented.

### DETAILED DESCRIPTION

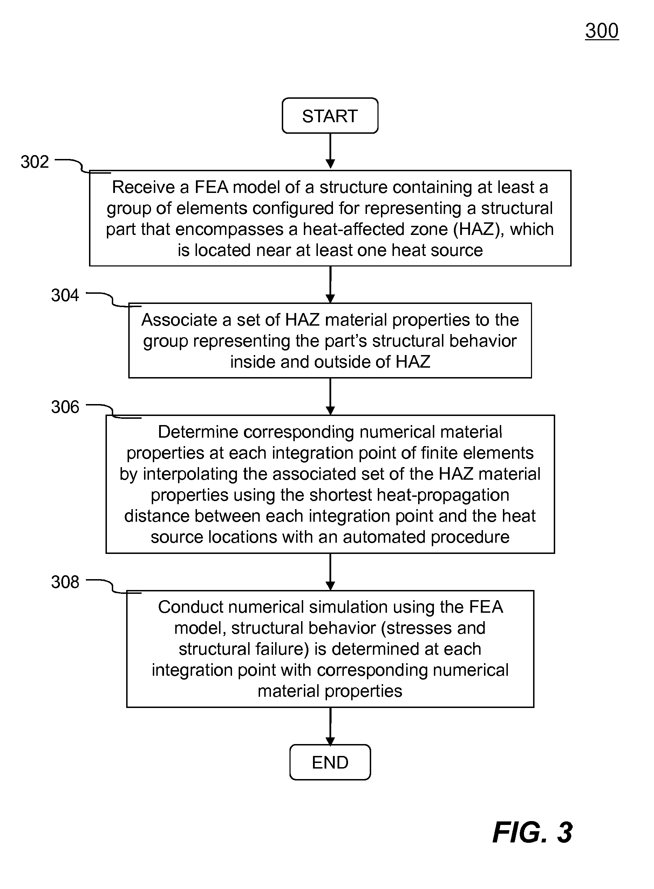

Referring first to FIG. 3, it is shown a flowchart illustrating an exemplary process 300 of conducting numerical simulation of a structure (e.g., car, airplane, or their components) having heat-affected zone (HAZ) using a finite element analysis (FEA) model, according to an embodiment of the present invention. Process 300 is preferably implemented in software.

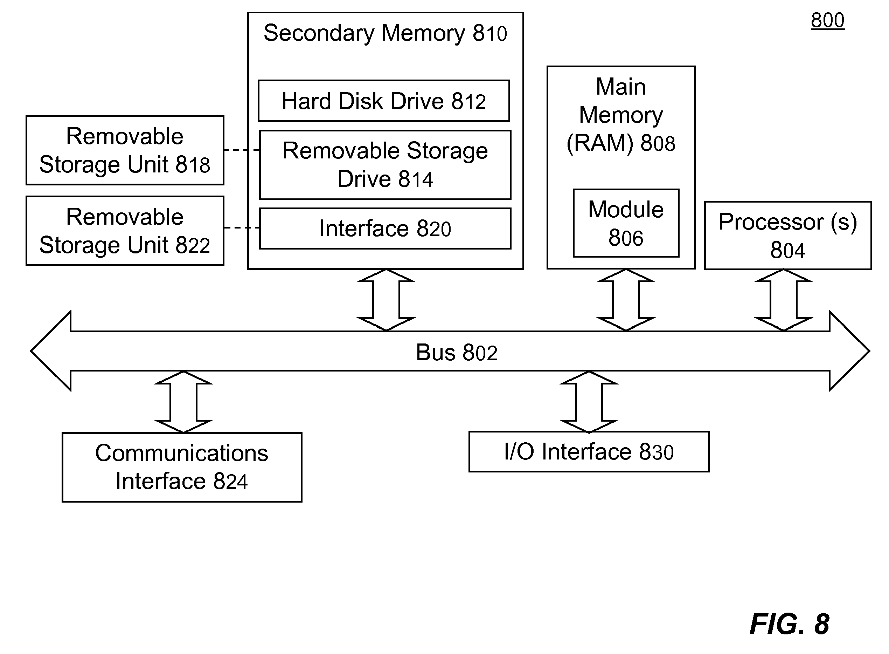

Process 300 starts, at step 302, by defining and receiving a finite element analysis (FEA) model in a computer system (e.g., computer 800 of FIG. 8) having a FEA application module installed thereon. The FEA model represents a structure and contains at least a group of finite elements configured for representing a welded structural part, which encompasses at least one heat-affected zone (HAZ).

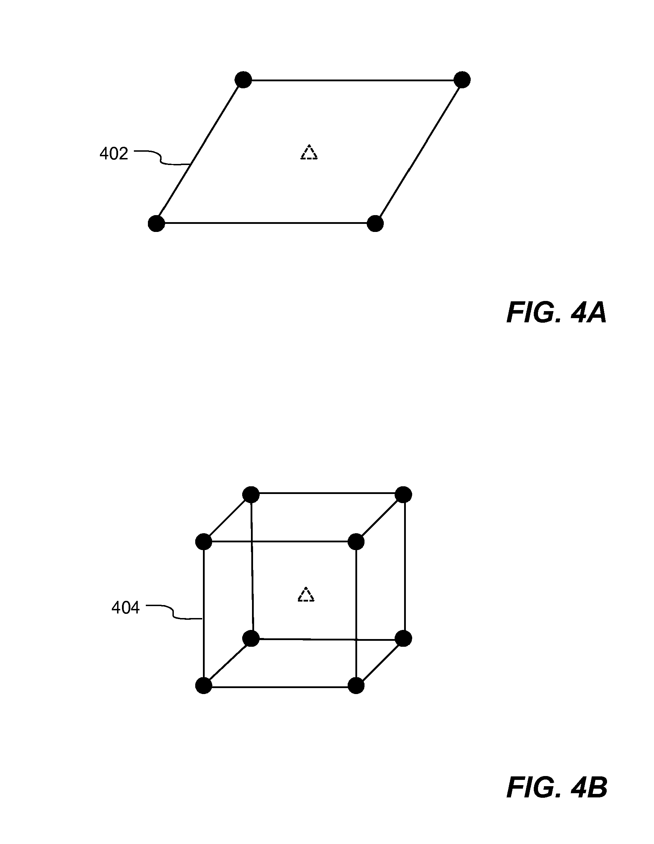

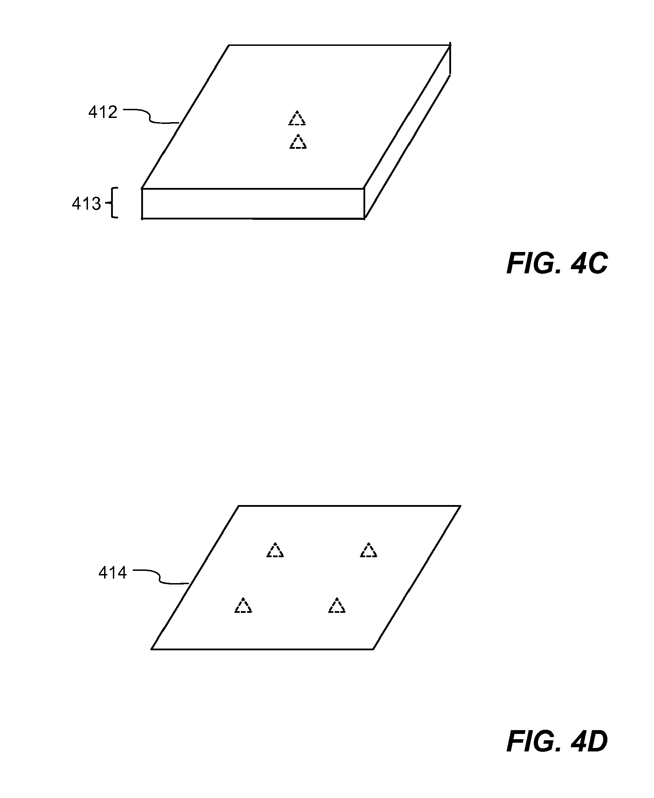

FIGS 4A-4D show various exemplary finite elements that can be used for representing a welded structural part in a FEA model. A two-dimensional quadrilateral membrane element 402 and a three-dimensional solid element 404 are shown in FIG. 4A and FIG. 4B, respectively. Each of these elements 402-404 contains a single integration point located in the centroid of the element. Further, FIG. 4C shows a quadrilateral shell element 412 contains two integration points (triangles) offset at the center through its thickness 413. A membrane element 414 having four planar integration points (triangles) is shown in FIG. 4D. Based on FEA, numerically simulated structural behaviors of the structure are calculated at each integration point. Since material properties vary significantly within the HAZ, numerical material properties at each integration point must be properly determined to predict realistic structural behavior.

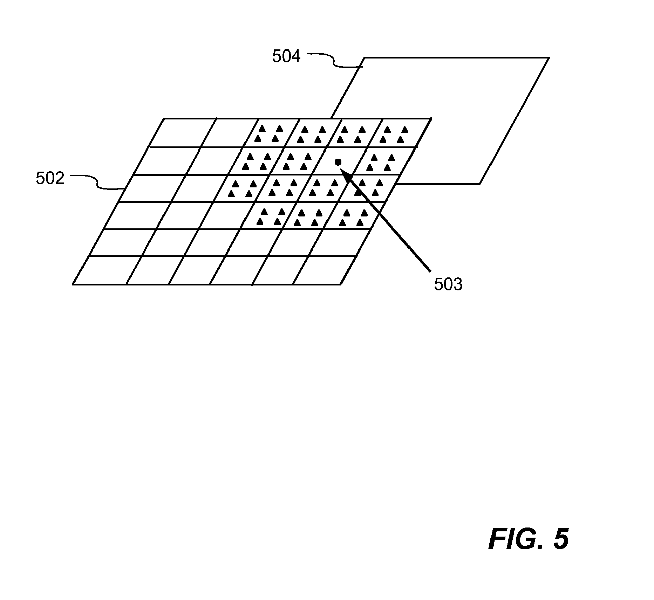

It is noted that a fully-integrated 8-node hexahedral element can have eight integration points (not shown). FIG. 5 is a diagram illustrating an exemplary FEA model containing a group of shell finite elements representing a welded structural part 502 (i.e., first plate on top) and a second plate at bottom) 504. First and second plates are connected by a spotweld 503, which is surrounded by a HAZ. Instead of explicitly assigning unique material properties to those elements in the HAZ, the present invention enables user to specify, within a given constitutive model, a set of HAZ material properties for the base material, which includes the variation within a HAZ. The material properties at the integration point are interpolated using the shortest heat-propagation distance from the center of a spotweld and assigned to the integration point (shown as triangles) with an automated procedure that requires no additional input after the HAZ material properties have been defined in accordance with one embodiment of the present invention. Rather than a single material property for one shell finite element, the material properties vary within the element for each integration point as a function of this distance from the closest spotweld in the vicinity of the integration point. The automated procedure can be implemented with well known techniques, for example, a three-dimensional table look-up.

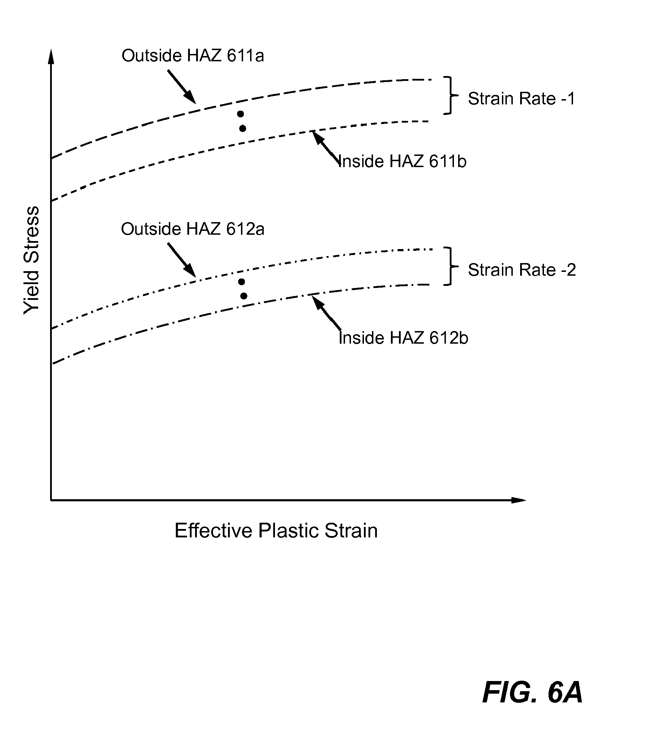

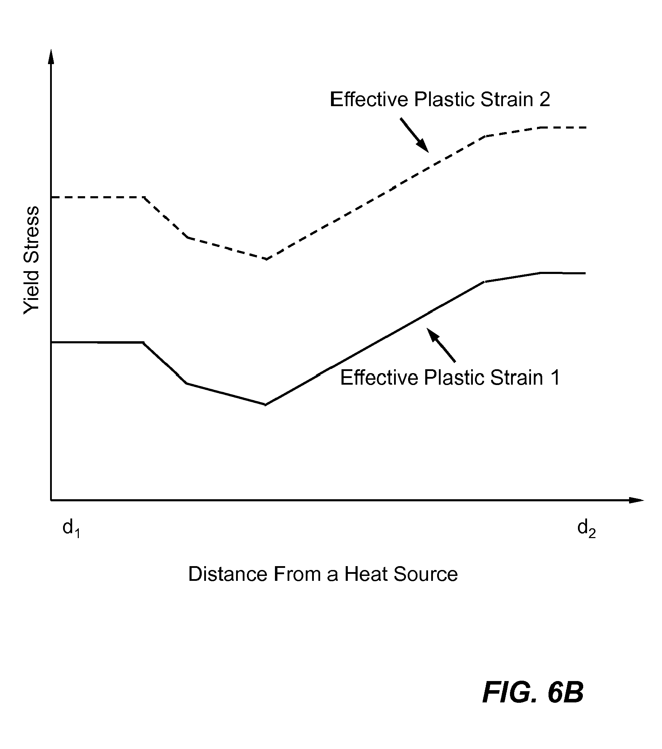

Referring back to step 304, a set of HAZ material properties is associated with the group of finite elements that represents a welded structural part. For example, part's structural behavior can be represented by a "yield stress"-versus-"effective plastic strain" relationship shown in FIG. 6A. Two set of curves are shown. The first set of curves 611a and 611b represent HAZ material properties at "strain rate-1" outside and inside of HAZ, respectively. Similarly, the second set of curves 612a and 612b represent numerical properties at "strain rate-2" outside and inside of HAZ. For illustration simplicity and clarity, only two curves are shown at each strain rate. In practice, there may be many more curves required, because structural behavior is altered significantly within HAZ. A set of curves of "yield stress"-versus-"distance from a weld" relationship are shown in FIG. 6B. The horizontal axis shows the distance from a heat source location in ascending order. In other words, "d₁" is closer to the weld and therefore smaller than "d₂". Furthermore, the relationship is non-linear. The weakest location is located in the middle of HAZ not closest to the weld.

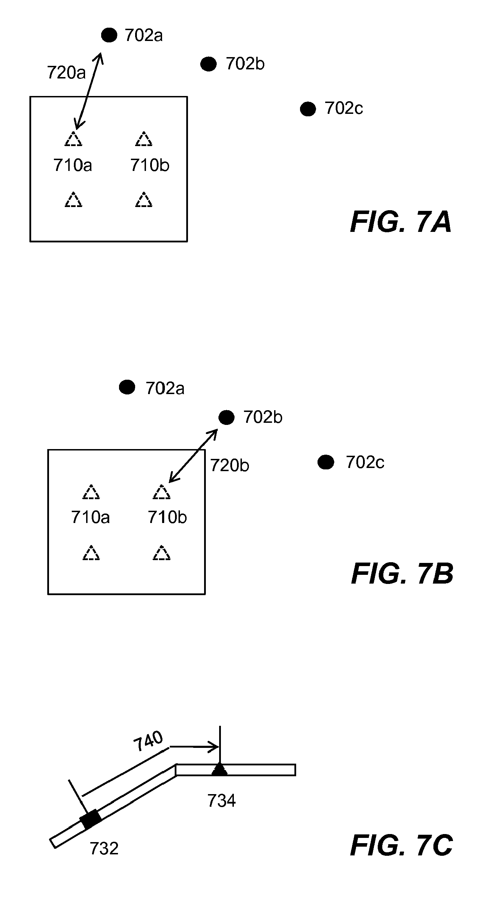

At step 306, after the set of HAZ material properties is associated with the group of finite elements, corresponding material properties are determined and assigned at each integration point by interpolating the associated set using the heat-propagation distance between each integration point and the closest heat source location. FIGS. 7A and 7B show diagrams illustrating the relationship between integration points 710a-710b of an exemplary finite element and various spotwelds 702a-702c. Shown in FIG. 7A, the heat-propagation distance at first integration point 710a is between the first integration point 710a and the spotweld 702a. For the second integration point 710b, the distance 720b is between a different spotweld 702b and the second integration point 710b. The interpolation can be done with a number ofknown methods, for example, linear interpolation, exponential interpolation, etc. This means that more than one material properties can be assigned to a single finite element to represent different structural behavior. FIG. 7C shows heat-propagation distance 740 is measured from the spotweld's center 732 to an integration point 734 along the surface where the spotweld connects and includes the effect of the curvature of the surface.

Further, the heat-propagation distance between each integration point and one of the heat source locations accounts for the warping of the finite element, for example, four nodes of certain two-dimensional quadrilateral shell element may not be coplanar.

At step 308, a numerical simulation of the structure can then be conducted using the FEA model with corresponding material properties determined at respective integration points to represent structural behavior.

According to one aspect, the present invention is directed towards one or more computer systems capable of carrying out the functionality described herein. An example of a computer system 800 is shown in FIG. 8. The computer system 800 includes one or more processors, such as processor 804. The processor 804 is connected to a computer system internal communication bus 802. Various software embodiments are described in terms of this exemplary computer system. After reading this description, it will become apparent to a person skilled in the relevant art(s) how to implement the invention using other computer systems and/or computer architectures.

Computer system 800 also includes a main memory 808, preferably random access memory (RAM), and may also include a secondary memory 810. The secondary memory 810 may include, for example, one or more hard disk drives 812 and/or one or more removable storage drives 814, representing a floppy disk drive, a magnetic tape drive, an optical disk drive, etc. The removable storage drive 814 reads from and/or writes to a removable storage unit 818 in a well-known manner. Removable storage unit 818, represents a floppy disk, magnetic tape, optical disk, etc. which is read by and written to by removable storage drive 814. As will be appreciated, the removable storage unit 818 includes a computer readable medium having stored therein computer software and/or data.

In alternative embodiments, secondary memory 810 may include other similar means for allowing computer programs or other instructions to be loaded into computer system 800. Such means may include, for example, a removable storage unit 822 and an interface 820. Examples of such may include a program cartridge and cartridge interface (such as that found in video game devices), a removable memory chip (such as an Erasable Programmable Read-Only Memory (EPROM), Universal Serial Bus (USB) flash memory, or PROM) and associated socket, and other removable storage units 822 and interfaces 820 which allow software and data to be transferred from the removable storage unit 822 to computer system 800. In general, Computer system 800 is controlled and coordinated by operating system (OS) software, which performs tasks such as process scheduling, memory management, networking and I/O services.

There may also be a communications interface 824 connecting to the bus 802. Communications interface 824 allows software and data to be transferred between computer system 800 and external devices. Examples of communications interface 824 may include a modem, a network interface (such as an Ethernet card), a communications port, a Personal Computer Memory Card International Association (PCMCIA) slot and card, etc.

The computer 800 communicates with other computing devices over a data network based on a special set of rules (i.e., a protocol). One of the common protocols is TCP/IP (Transmission Control Protocol/Internet Protocol) commonly used in the Internet. In general, the communication interface 824 manages the assembling of a data file into smaller packets that are transmitted over the data network or reassembles received packets into the original data file. In addition, the communication interface 824 handles the address part of each packet so that it gets to the right destination or intercepts packets destined for the computer 800.

In this document, the terms "computer recordable storage medium", "computer recordable medium" and "computer readable medium" are used to generally refer to media such as removable storage drive 814, and/or a hard disk installed in hard disk drive 812. These computer program products are means for providing software to computer system 800. The invention is directed to such computer program products.

The computer system 800 may also include an input/output (I/O) interface 830, which provides the computer system 800 to access monitor, keyboard, mouse, printer, scanner, plotter, and alike.

Computer programs (also called computer control logic) are stored as application modules 806 in main memory 808 and/or secondary memory 810. Computer programs may also be received via communications interface 824. Such computer programs, when executed, enable the computer system 800 to perform the features of the present invention as discussed herein. In particular, the computer programs, when executed, enable the processor 804 to perform features of the present invention. Accordingly, such computer programs represent controllers of the computer system 800.

In an embodiment where the invention is implemented using software, the software may be stored in a computer program product and loaded into computer system 800 using removable storage drive 814, hard drive 812, or communications interface 824. The application module 806, when executed by the processor 804, causes the processor 804 to perform the functions of the invention as described herein.

The main memory 808 may be loaded with one or more application modules 806 (e.g., a finite element analysis application module) that can be executed by one or more processors 804 with or without a user input through the I/O interface 830 to achieve desired tasks (e.g., determining corresponding material properties at each integration point). In operation, when at least one processor 804 executes one of the application modules 806, the results are computed and stored in the secondary memory 810 (i.e., hard disk drive 812). The status of the time-marching engineering simulation (e.g., stress and failure of a finite element, etc.) is reported to the user via the I/O interface 830 either in a text or in a graphical form.

Although the present invention has been described with reference to specific embodiments thereof, these embodiments are merely illustrative, and not restrictive of, the present invention. Various modifications or changes to the specifically disclosed exemplary embodiments will be suggested to persons skilled in the art. For example, whereas numerical material properties have been shown and described as two sets of "yield stress"-versus-"effective plastic strain" curves in a X-Y diagram, other equivalent means for representing numerical material properties can be used for achieving the same, for example, a three-dimensional lookup table storing corresponding numbers reflecting the curves in the X-Y diagram. Additionally, whereas quadrilateral finite elements have been shown and described to demonstrate embodiments of the present invention, other type of finite elements can be used for achieving the same, for example, triangular elements. Further, whereas four integration points per membrane element have been shown and described, other numbers of integration points may be used, for example, two integration points through the thickness of the shell element. Finally, whereas welding has been shown and described as the heat source, other types of manufacturing process may cause similar material damage or degradation, for example, trimming or cutting a sheet metal. In summary, the scope of the invention should not be restricted to the specific exemplary embodiments disclosed herein, and all modifications that are readily suggested to those of ordinary skill in the art should be included within the spirit and purview of this application and scope of the appended claims.

## Claims

1. A method of conducting numerical simulation of a structure containing heat-affected zone (HAZ) using a finite element analysis (FEA) model, said method comprising:
receiving, in a computer system having a FEA application module installed thereon, a FEA model having at least a group of finite elements configured for representing a welded part that encompasses a HAZ and each of said group of finite elements being configured with at least one integration point for numerical integration in FEA, wherein the HAZ is located near at least one heat source location;
associating a set of HAZ material properties to said group of finite elements, wherein said set of HAZ material properties represents the welded part's structural behavior inside and outside of the HAZ;
determining corresponding numerical material properties at each integration point by interpolating the associated set of HAZ material properties using shortest heat-propagation distance between said each integration point and the at least one heat source location with an automated procedure that requires no additional input after the HAZ material properties have been defined; and
conducting a numerical simulation of the structure using the FEA model in the computer system with said corresponding numerical material properties determined at said each integration point.

2. The method of Claim 1, wherein the group of finite elements comprises finite elements both inside and outside of the HAZ.

3. The method of Claim 2, wherein the group of finite elements comprises two-dimensional finite elements.

4. The method of Claim 2, wherein the group of finite elements comprises three-dimensional finite elements.

5. The method of Claim 1, wherein said welded part is joined together with at least one spotweld and said at least one heat source location corresponds to said at least one spotweld's centroid.

6. The method of Claim 1, wherein said welded part is made from a tailor welded blank sheet metal and said at least one heat source location is a centerline of a butt weld seam of the tailor welded blank sheet metal.

7. The method of Claim 1, wherein said part is made from a blank sheet metal and said at least one heat source location is a centerline of a trim line of the blank sheet metal.

8. The method of Claim 1, wherein a set of HAZ material properties comprises relationship between yield stress and effective plastic strain at different strain rates of the welded part.

9. The method of Claim 1, wherein the welded part's structural behavior inside and outside of the HAZ is a function of heat-propagation distance measured from said at least one heat source location.

10. The method of Claim 1, wherein the shortest heat-propagation distance accounts for warping of the finite element between said each integration point and the at least one heat source location.

11. The method of Claim 1, wherein said group of the finite element includes more than one integration points and two of said more than one integration points are assigned different numerical material properties.

12. The method of Claim 1, wherein the shortest heat-propagation distance is measured along a surface where the at least one heat source connects and includes the surface's curvature effect.

13. The method of Claim 1, wherein the automated procedure comprises using a three-dimensional table look-up scheme, where the three-dimensional table contains the set of HAZ material properties at various distance from the heat source location.

14. A system for conducting numerical simulation of a structure having heat-affected zone (HAZ) using a finite element analysis (FEA) model, said system comprising:
a main memory for storing computer readable code for a finite element analysis application module;
at least one processor coupled to the main memory, said at least one processor executing the computer readable code in the main memory to cause the FEA application module to perform operations by a method of:
receiving a FEA model having at least a group of finite elements configured for representing a welded part that encompasses a HAZ and each of said group of finite elements being configured with at least one integration point for numerical integration in FEA, wherein the HAZ is located near at least one heat source location;
associating a set of HAZ material properties to said group of finite elements, wherein said set of HAZ material properties represents the welded part's structural behavior inside and outside of the HAZ;
determining corresponding numerical material properties at each integration point by interpolating the associated set using shortest heat-propagation distance between said each integration point and the at least one heat source location with an automated procedure that requires no additional input after the HAZ material properties have been defined; and
conducting a numerical simulation of the structure using the FEA model in the computer system with said corresponding numerical material properties determined at said each integration point.

15. A non-transitory computer readable storage medium containing instructions for controlling a computer system for conducting numerical simulation of a structure having heat-affected zone (HAZ) using a finite element analysis (FEA) model by a method comprising:
receiving, in a computer system having a FEA application module installed thereon, a FEA model having at least a group of finite elements configured for representing a welded part that encompasses a HAZ and each of said group of finite elements being configured with at least one integration point for numerical integration in FEA, wherein the HAZ is located near at least one heat source location;
associating a set of HAZ material properties to said group of finite elements, wherein said set of HAZ material properties represents the welded part's structural behavior inside and outside of the HAZ;
determining corresponding numerical material properties at each integration point by interpolating the associated set using shortest heat-propagation distance between said each integration point and the at least one heat source location with an automated procedure that requires no additional input after the HAZ material properties have been defined; and
conducting a numerical simulation of the structure using the FEA model in the computer system with said corresponding numerical material properties determined at said each integration point.
